# FASCICULE DE BREVET EUROPEEN

(11) **EP 0 761 076 B1**
(45) Date de publication et mention de la délivrance du brevet: **26.08.1998**
(21) Numéro de dépôt: 95920820.8
(22) Date de dépôt: 17.05.1995
(51) Int. Cl.: H05K 5/00, H05K 7/14

(54) **DISPOSITIF DE MAINTIEN DE PLAQUES ARTICULEES DANS UN BOITIER ELECTRONIQUE**
HALTERUNGSVORRICHTUNG FÜR LEITERPLATTEN MIT ELEKTRONISCHEN BAUELEMENTEN
DEVICE FOR HOLDING HINGE PLATES WITHIN AN ELECTRONIC CASE

(30) Priorité: 27.05.1994 FR 9406578
(43) Date de publication de la demande: 12.03.1997
(73) Titulaire: SIEMENS AUTOMOTIVE S.A., 31036 Toulouse Cédex (FR)
(72) Inventeur: JUREK, Gilles, F-31830 Plaisance-du-Touch (FR); RILLY, Patrice, F-31600 Muret (FR)
(74) Mandataire: Epping, Wilhelm, Dr.-Ing.
(86) Numéro de dépôt international: EP9501866
(87) Numéro de publication internationale: WO9533363

(56) Documents cités:
- DE-A- 3 936 906
- FR-A- 2 669 179

## Description

La présente invention concerne un dispositif de maintien d'une pluralité de plaques de support de composants électroniques. Plus particulièrement le dispositif selon l'invention est adapté pour réaliser le maintien momentané d'au moins deux plaques de support reliées l'une à l'autre et formant un parallélogramme déformable. Ces plaques de support sont destinées à être placées dans un boîtier électronique embarqué dans un véhicule automobile.

Il est déjà connu de réaliser des boîtiers électroniques composés de plusieurs plaques reliées entre elles de manière électrique et / ou mécanique; cf. DE-A-39 36 906. De manière générale ces plaques sont associées par des charnières (lorsque les plaques doivent présenter une certaine mobilité l'une par rapport à l'autre) ou bien sont fixées l'une à l'autre de manière définitive par vissage, collage, soudure etc.

Pour réaliser un boîtier électronique, comportant une pluralité de plaques reliées les unes aux autres, il faut pouvoir maintenir ces plaques, dans une position prédéterminée, au moment de leur assemblage. A cet effet il est impossible d'utiliser des charnières entre les plaques car celles ci auraient tendance à toumer autour de leur axe de rotation et la position des plaques les unes par rapport aux autres, ne serait pas fixée. Il est également impensable de les coller, de les souder ou de les visser dans une position prédéterminée car cela prendrait trop de temps, dans le processus de fabrication. En outre bien qu'un positionnement déterminé des plaques les unes par rapport aux autres soit recherché, il est tout de même nécessaire que ce positionnement présente une légère souplesse lors de l'introduction des plaques dans le boîtier. De ce fait ni les solutions de maintien pivotant (charnières) connues à ce jour ni les solutions de maintien rigide ne conviennent pour verrouiller temporairement la position des différentes plaques destinées à constituer le boîtier électronique recherché.

La présente invention a pour objet de créer un dispositif de maintien en position d'une pluralité de plaques, de manière temporaire. Ce dispositif doit être peu onéreux, fiable, facile à fabriquer et à mettre en place.

A cet effet la présente invention concerne un dispositif de maintien en position d'au moins une première et une seconde plaque l'une par rapport à l'autre, les dites plaques étant adaptées pour être disposées dans un boîtier et pour supporter une pluralité de composants électroniques. Ce dispositif se caractérise en ce qu'il comporte répartis entre chaque plaque support à maintenir:
- au moins une paire de languettes de fixation présentant chacune une longueur déterminée et étant munie d'un élément de fixation et,
- au moins une paire de moyens de fixation adaptés pour coopérer avec les éléments de fixation des languettes, les dits moyens de fixation présentant des axes de fixation décalés l'un par rapport à l'autre.

Grâce à ces dispositions, les différentes plaques appelées à constituer un boîtier sont reliées temporairement de telle sorte que leurs positions les unes par rapport aux autres soient fixes. Ce positionnement est réalisé simplement par la coopération des éléments de fixation des languettes avec les moyens de fixation.

Avantageusement les plaques ne peuvent pas tourner l'une par rapport à l'autre car les axes des moyens de fixation sont décalés l'un par rapport à l'autre et ne peuvent constituer une charnière.

Avantageusement encore, on notera que les languettes et les moyens de fixation font partie intégrante de chaque plaque support.

On notera encore que la répartition des languettes de fixation et des moyens de fixation sur l'une ou l'autre des deux plaques à maintenir est quelconque. A chaque languette est associé un moyen de fixation correspondant sur la plaque opposée, mais toutes les languettes peuvent se situer ou non sur une même plaque.

D'autres objets caractéristiques et avantages de la présente invention ressortiront d'ailleurs de la description qui suit à titre d'exemple non limitatif, en référence aux dessins annexés dans lesquels:
- la figure 1 est une vue schématique en élévation montrant des plaques de support selon l'invention telles qu'elles sont positionnées dans un boîtier électronique,
- la figure 2 est une vue schématique en plan, montrant deux plaques support munies du dispositif selon la présente invention, et
- la figure 3 est une vue schématique en coupe selon la ligne II-II de la

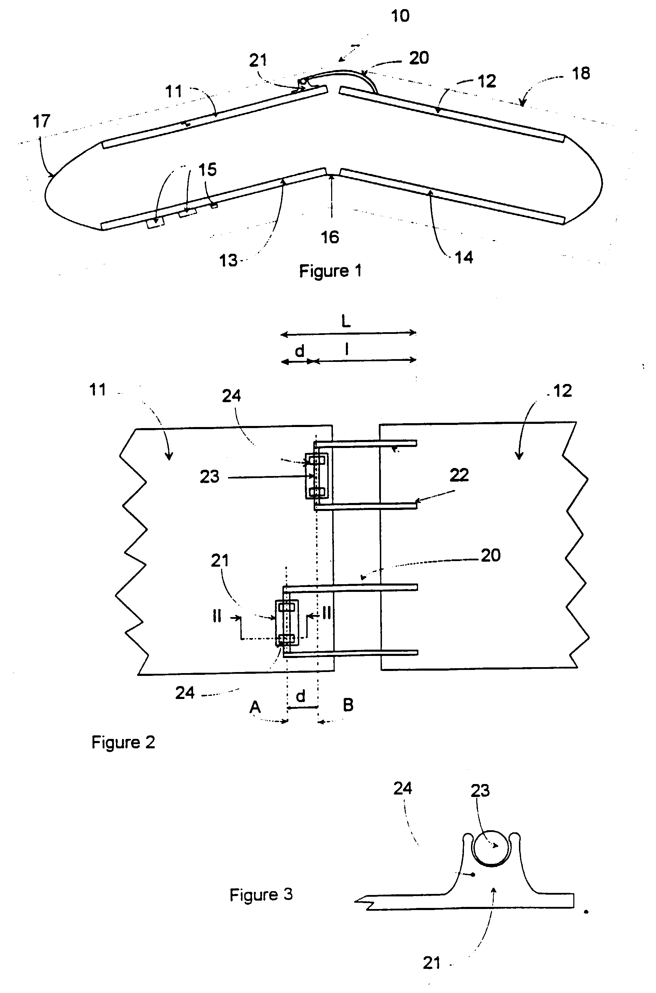

figure 2. Selon la forme de réalisation décrite et représentée aux figures 1 à 3 le dispositif de maintien 10 selon l'invention est mis en place entre deux plaques de support 11 et 12 (dites plaques de support supérieures) adaptées pour coopérer avec deux autres plaques support 13 et 14 (dites plaques de support inférieures), auxquelles elles sont liées. L'ensemble des plaques de support 11, 12, 13, 14 constitue un parallélogramme déformable (figure 1).

Chaque plaque de support est adaptée pour recevoir une pluralité de composants électroniques 15. Pour la clarté du dessin, seuls quelques composants ont été représentés à la figure 1.

Les plaques de support inférieures 13 et 14 sont reliées entre elles par une liaison rigide 16.

Un circuit imprimé flexible 17 recouvre l'ensemble des plaques de support 11, 12, 13, 14 et relie de manière souple les plaques 11 et 13 ainsi que les plaques 14 et 12. Les plaques de support supérieures 11 et 12 ne sont pas directement reliées par le circuit imprimé flexible.

Lors du processus de fabrication l'ensemble des plaques support est, dans un premier temps, mis à plat. Les plaques support sont ainsi disposées les unes derrière les autres et le circuit imprimé flexible est collé sur l'ensemble de ces plaques. Les composants électroniques 15 sont, dans un deuxième temps, mis en place sur l'ensemble des plaques alors que celles ci sont toujours en position déployée (à plat les unes derrière les autres).

Dans un troisième temps, les plaques de support inférieures 13 et 14 sont maintenues par un châssis rigide (non représenté) et les plaques de support supérieure 11 et 12 sont repliées sur les plaques inférieures 13 et 14 de telle sorte qu'elles forment l'ensemble représenté à la figure 1. Pour maintenir les plaques de support supérieures 11 et 12 dans une telle position il est nécessaire de leur adjoindre un dispositif de maintien 10. Ce dispositif ne sert qu'au maintien momentané des plaques de support supérieures 11 et 12. En effet ces plaques sont ensuite placées dans un boîtier 18 qui les maintient rigidement. C'est ce dispositif 10 de maintien momentané qui est l'objet de la présente invention et qui va être plus amplement décrit ci-après.

Le dispositif de maintien 10, selon l'invention comporte (figure 2):
- une paire de languettes 20 et,
- une paire de moyen de fixation 21. Chaque languette 20 est adaptée pour coopérer avec un moyen de fixation 21 correspondant.

Chaque languette 20 est constituée de deux branches 22 reliées l'une à l'autre, à l'une de leur extrémité, par un élément de fixation 23. Cet élément de fixation 23 présente une forme globalement cylindrique (figure 3), et est adapté pour se loger dans un socle de réception 24, appartenant au moyen de fixation 21 correspondant. On notera que chacune des languettes est réalisée de manière intégrale avec la plaque support sur laquelle elle est ménagée. Dans l'exemple représenté, une des plaques de support 12 porte deux languettes de fixation, et l'autre plaque support 11 porte les moyens de fixation 21 correspondants.

Chaque moyen de fixation 21 est réalisé de manière intégrale avec la plaque support qui le porte.

Les languettes et les moyens de fixation sont réalisés, tout comme les plaques support, en matériau synthétique et il est très facile de réaliser des moules incorporant ces éléments 20,21 sans augmenter de manière inconsidérée les coûts de réalisation des moules.

Selon l'une des caractéristiques de l'invention chaque languette 20 présente une longueur déterminée. Ainsi une première languette 20 (figure 2) présente une longueur I et une seconde languette présente une longueur L. Cette différence de longueur influe sur la position des moyens de fixation placés en correspondance sur la plaque de support 11. On remarque ainsi que les deux moyens de fixation 21 placés sur la plaque de support 11 présentent des axes de fixation A et B décalés l'un par rapport à l'autre, d'une distance d. Cette distance d est égale à la différence des longueurs L - I des languettes 20.

Pour maintenir dans une position prédéterminée les plaques de support 11 et 12 il suffit d'engager les éléments de fixation 23 des languettes, dans les socles 24 (figure 3) correspondants des moyens de fixation 21. Ce faisant les plaques de support 11 et 12 sont maintenues l'une par rapport à l'autre à une distance prédéterminée. En outre, comme les axes de fixation A et B sont décalés l'un par rapport à l'autre, il est impossible que la plaque de support 11 tourne autour de l'un de ces axes. Ainsi la position des deux plaques de support 11 et 12 est maintenue, avec possibilité de très faibles déplacements (jeux) des plaques de support 11 et 12 l'une par rapport à l'autre.

On notera qu'une fois maintenue en position l'une par rapport à l'autre tel que précédemment décrit, les plaques support sont mises en place dans un boîtier 18. Ce boîtier est simplement schématisé par une ligne pointillée à la figure 1. Lors de cette mise en place il peut être nécessaire d'avoir une certaine souplesse des plaques entre elles. Avantageusement le dispositif de maintien selon l'invention permet de disposer d'un certain jeu entre les plaques de support. La mise en place dans le boîtier électronique en est ainsi facilitée.

On notera en outre que, le dispositif de maintien selon l'invention peut très bien rester en place en position active et de manière définitive dans le boîtier électronique. Il n'est donc pas nécessaire une fois les plaques mises en place dans le boîtier, de désaccoupler les plaques de support entre elles.

On notera que la répartition des moyens de fixation 21 et des languettes peut être différente de celle représentée. Notamment chaque plaque de support peut présenter un moyen de fixation 21 et une languette 20.

En variante encore les languettes 20 peuvent ne comporter qu'une seule branche 22 et dans ce cas l'élément de fixation 23 est simplement porté par cette branche 22. Les moyens d'emboîtement élastique des éléments de fixation 23 dans les socles 24 peuvent être constitués par tous dispositifs analogues à ceux représentés.

En variante, il est possible de munir deux plaques de support adjacentes d'une pluralité de languettes coopérant avec une pluralité de moyens de fixation.

Bien entendu, la présente invention telle que définie dans la revendication 1 n'est pas limitée au mode de réalisation choisi et représenté et englobe toutes variantes à la portée de l'homme de l'art. Ainsi le dispositif selon l'invention peut être utilisé pour maintenir en place une pluralité de plaques les unes par rapport aux autres, et non uniquement deux plaques support, comme précédemment décrit.

## Revendications

1. Dispositif de maintien en position d'au moins une première (11) et une seconde (12) plaque l'une par rapport à l'autre, les dites plaques étant adaptées pour être disposées dans un boîtier (18) et pour supporter une pluralité de composants électroniques (15), le dit dispositif étant caractérisé en ce qu'il comporte répartis entre chacune des plaques de support à maintenir:
- au moins une paire de languettes de fixation (20) présentant chacune une longueur( L, I) déterminée et étant munie d'un élément de fixation (23) et
- au moins une paire de moyens de fixation (21) adaptés pour coopérer avec les éléments de fixation (23) des languettes, chaque moyen de fixation présentant un axe de fixation ( A, B) décalé par rapport à celui de l'autre moyen de fixation.

2. Dispositif de maintien selon la revendication 1, caractérisé en ce que les éléments de fixation (23) coopèrent avec les moyens de fixation (21) par emboîtement élastique.

3. Dispositif de maintien selon la revendication 1 ou 2, caractérisé en ce que les dites languettes (20) sont constituées de deux branches (22) ancrées dans la matière d'une des plaques (11,12), les dites branches (22)étant reliées entre elles par l'élément de fixation (23).

4. Dispositif de maintien selon la revendication 1, caractérisé en ce que les moyens de fixation (21) comportent un socle de réception (24) pour l'élément de fixation (23).

5. Dispositif de maintien selon l'une des revendications 1 à 4 caractérisé en ce que la paire de languettes (20) est disposée sur la première plaque (11) et la paire de moyens de fixation (21) est disposée en correspondance sur la seconde plaque (12).

6. Dispositif de maintien selon l'une des revendications 1 à 4 caractérisé en ce que la paire de languettes (20) est répartie sur chacune des plaques (11, 12) à maintenir et en ce que la paire de moyens de fixation (21) est disposée en correspondance sur chacune des plaques (11, 12) à maintenir.

## Patentansprüche

1. Vorrichtung zum Halten mindestens einer ersten Platte (11) und einer zweiten Platte (12) in einer Position relativ zueinander, welche Platten in einem Gehäuse (18) angeordnet werden können und zum Abstützen mehrerer elektronischer Bauelemente (5) dienen, wobei die Vorrichtung dadurch gekennzeichnet ist, daß sie, verteilt zwischen jeder der zum Halten dienenden Trägerplatten, aufweist:
- mindestens ein Paar Befestigungslaschen (20), die jeweils eine vorgegebene Länge (L,l) haben und mit einem Befestigungselement (23) versehen sind, und
- mindestens ein Paar Befestigungsmittel (21), die mit den Befestigungselementen (23) der Laschen zusammenwirken, wobei jedes Befestigungsmittel eine Befestigungsachse (A,B) aufweist, die bezüglich derjenigen des anderen Befestigungsmittels versetzt ist.

2. Vorrichtung nach Anspruch 1, dadurch gekennzeichnet, daß die Befestigungselemente (23) mit den Befestigungsmitteln (21) durch eine elastische Verbindung zusammenwirken.

3. Vorrichtung nach Anspruch 1 oder 2, dadurch gekennzeichnet, daß die Laschen (20) von zwei Armen (22) gebildet werden, die in dem Material einer der Platten (11,12) verankert sind, wobei die Arme (22) untereinander durch das Befestigungselement (23) verbunden sind.

4. Vorrichtung nach Anspruch 1, dadurch gekennzeichnet, daß die Befestigungsmittel (21) einen Aufnahtnesockel (24) für das Befestigungselement (23) aufweisen.

5. Vorrichtung nach einem der Ansprüche 1 bis 4, dadurch gekennzeichnet, daß das Laschenpaar (20) an der ersten Platte (11) angeordnet ist und das Befestigungsmittelpaar (21) passend hierzu an der zweiten Platte (12) angeordnet ist.

6. Vorrichtung nach einem der Ansprüche 1 bis 4, dadurch gekennzeichnet, daß das Laschenpaar (20) auf jede der Halteplatten (11,12) verteilt ist und daß das Befestigungsmittelpaar (21) dazu passend an jeder der Halteplatten (11,12) angeordnet ist.

## Claims

1. Device for holding in position relative to each other at least a first plate (11) and a second plate (12), the said plates being designed to be placed in a unit (18) and to support a number of electronic components (15), the said device being characterized in that it comprises, distributed between each of the support plates to be held:
- at least one pair of attachment tabs (20) each having a given length (L, l) and being fitted with an attachment element (23), and
- at least one pair of attachment means (21) designed to interact with the attachment elements (23) of the tabs, each attachment means having an attachment axis (A, B) which is offset from that of the other attachment means.

2. Holding device according to Claim 1, characterized in that the attachment elements (23) interact with the attachment means (21) by elastic push-fitting.

3. Holding device according to Claim 1 or 2, characterized in that the said tabs (20) consist of two branches (22) anchored into the substance of one of the plates (11, 12), the said branches (22) being joined together by the attachment element (23).

4. Holding device according to Claim 1, characterized in that the attachment means (21) comprise a base (24) for accommodating the attachment element (23).

5. Holding device according to one of Claims 1 to 4, characterized in that the pair of tabs (20) is situated on the first plate (11) and the pair of attachment means (21) is situated facing it on the second plate (12).

6. Holding device according to one of Claims 1 to 4, characterized in that the pair of tabs (20) is distributed over each of the plates (11, 12) to be held and in that the pair of attachment means (21) is situated facing it on each of the plates (11, 12) to be held.
